# EUROPÄISCHE PATENTANMELDUNG

(11) **EP 4 300 997 A1**
(43) Veröffentlichungstag der Anmeldung: **03.01.2024**
(21) Anmeldenummer: 23180433.7
(22) Anmeldetag: 20.06.2023
(51) Int. Cl.: H04R 25/00, H05K 1/18

(54) **ELEKTRONIKMODUL UND HÖRINSTRUMENTE-GRUNDMODUL FÜR EIN IN DEM GEHÖRGANG ZU TRAGENDES HÖRINSTRUMENT, IN DEM GEHÖRGANG ZU TRAGENDES HÖRINSTRUMENT**

(30) Priorität: 30.06.2022 DE 102022206739
(71) Anmelder: Sivantos Pte. Ltd., Singapore 539775 (SG)
(72) Erfinder: VON MANSBERG, Thilo, 91058 Erlangen (DE); STEFFEN, Marco, 32584 Löhne (DE); MENKE, Alexander, 32584 Löhne (DE)
(74) Vertreter: FDST Patentanwälte

(57) **Zusammenfassung**

Die Erfindung betrifft ein Elektronikmodul (72) für ein im Gehörgang zu tragendes Hörinstrument (1), aufweisend eine wiederaufladbare Batterie (20), einen mechanischen Halter (24), in dem die wiederaufladbare Batterie (20) im bestimmungsgemäßen Montagezustand des Elektronikmoduls (72) aufgenommen ist, einen Schaltungsträger (12), und einen auf dem Schaltungsträger (12) angeordneten Chipsatz (14), wobei der Schaltungsträger (12) bandartig ausgebildet ist und im bestimmungsgemäßen Montagezustand abschnittsweise und gebogen um den mechanischen Halter (24) herum gelegt ist.

## Beschreibung

Die Erfindung betrifft ein Elektronikmodul sowie ein Hörinstrumente-Grundmodul für ein in dem Gehörgang zu tragendes Hörinstrument. Außerdem betrifft die Erfindung ein solches in dem Gehörgang zu tragendendes Hörinstrument.

Hörinstrumente dienen üblicherweise zur Ausgabe eines Tonsignals an das Gehör des Trägers dieser Hörvorrichtung. Die Ausgabe erfolgt dabei mittels eines Ausgabewandlers, meist auf akustischem Weg über Luftschall mittels eines Lautsprechers (auch als "Hörer" oder "Receiver" bezeichnet). Häufig kommen derartige Hörinstrumente dabei als sogenannte Hörhilfegeräte (auch kurz: Hörgeräte) zum Einsatz. Dazu umfassen die Hörinstrumente normalerweise einen akustischen Eingangswandler (insbesondere ein Mikrophon) und einen Signalprozessor, der dazu eingerichtet ist, das von dem Eingangswandler aus dem Umgebungsschall erzeugte Eingangssignal (auch: Mikrophonsignal) unter Anwendung mindestens eines üblicherweise nutzerspezifisch hinterlegten Signalverarbeitungsalgorithmus derart zu verarbeiten, dass eine Hörminderung des Trägers des Hörinstruments zumindest teilweise kompensiert wird. Insbesondere im Fall eines Hörhilfegeräts kann es sich bei dem Ausgabewandler neben einem Lautsprecher auch alternativ um einen sogenannten Knochenleitungshörer oder ein Cochlea-Implantat handeln, die zur mechanischen oder elektrischen Einkopplung des Tonsignals in das Gehör des Trägers eingerichtet sind. Unter dem Begriff Hörinstrument fallen zusätzlich insbesondere auch Geräte wie z.B. sogenannte Tinnitus-Masker, Headsets, Kopfhörer und dergleichen.

Typische Bauformen von Hörinstrumenten, insbesondere Hörgeräten, sind Hinter-dem-Ohr- ("BTE"-) und In-dem-Ohr- ("IdO"- oder"ITE"-) Hörinstrumente. Diese Bezeichnungen zielen auf die bestimmungsgemäße Trageposition ab. So weisen Hinter-dem-Ohr-Hörinstrumente ein (Haupt-) Gehäuse auf, das hinter der Ohrmuschel getragen wird. Hier kann in Modelle unterschieden werden, deren Lautsprecher in diesem Gehäuse angeordnet ist - die Schallausgabe an das Ohr erfolgt dabei üblicherweise mittels eines Schallschlauchs, der im Gehörgang getragen wird - sowie in Modelle, die einen externen Lautsprecher, der im Gehörgang platziert wird, aufweisen. In-dem-Ohr-Hörinstrumente weisen hingegen ein Gehäuse auf, das in der Ohrmuschel oder sogar vollständig im Gehörgang getragen wird.

ITE-Hörinstrumente (auch kurz: "ITEs") weisen meist auch unterschiedliche Ausprägungen auf, nämlich Modelle, die vollständig im Gehörgang "versenkt" getragen werden (unter anderem auch als "CIC" für "completely in canal" bezeichnet), sowie Modelle, die teilweise im Gehörgang einliegen und teilweise in der Ohrmuschel offenliegen.

Die Energieversorgung der elektrischen und elektronischen Komponenten, insbesondere des Signalprozessors, des Mikrophons und Lautsprechers, erfolgt zunehmend mittels Sekundärzellen, d. h. wiederaufladbaren Batterien. Problematisch im Hinblick auf ITEs ist dabei, dass Sekundärzellen, sollen diese fest im Hörinstrument verbaut bleiben, um nicht ähnlich wie herkömmliche Batteriezellen gewechselt werden zu müssen, ein Energiemanagement erfordern, das einerseits den Ladezustand des Sekundärzelle überwacht, während eines Ladevorgangs die Zuführung der Ladeenergie zur Sekundärzelle sowie während des Betriebs die Energieverteilung auf die elektrischen und elektronischen Komponenten steuert. Zudem sind Mittel zum Empfang der Ladeenergie, insbesondere also wenigstens zwei auf unterschiedlichem elektrischem Potential liegende Kontakte erforderlich. Diese erforderlichen Komponenten erfordern erkanntermaßen Bauraum, der insbesondere bei ITEs, gerade bei CICs nur in geringem Maß zur Verfügung steht.

Der nur begrenzt zur Verfügung stehende Bauraum muss also möglichst effizient genutzt werden. Problematisch ist dabei aber unter anderem auch, dass elektromagnetische Störfelder zwischen Signalprozessor und Energiemanagement und/oder Ladekontakten auftreten können, die es zu vermeiden gilt (auch häufig als elektromagnetische Verträglichkeit benannt). Außerdem müssen die jeweiligen Komponenten auch mechanisch gelagert werden.

Der Erfindung liegt die Aufgabe zugrunde, ein verbessertes ITE-Hörinstrument zu ermöglichen.

Diese Aufgabe wird erfindungsgemäße gelöst durch ein Elektronikmodul mit den Merkmalen des Anspruchs 1. Des Weiteren wird diese Aufgabe erfindungsgemäß gelöst durch eine Hörinstrumente-Grundmodul mit den Merkmalen des Anspruchs 14. Außerdem wird diese Aufgabe erfindungsgemäß gelöst durch ein Hörinstrument mit den Merkmalen des Anspruchs 17. Weitere vorteilhaft und teils für sich erfinderische Ausführungsformen und Weiterbildungen der Erfindung sind in den Unteransprüchen sowie der nachfolgenden Beschreibung näher dargelegt.

Das erfindungsgemäße Elektronikmodul ist zum Einsatz in einem im Gehörgang zu tragenden Hörinstrument (im Folgenden kurz: "ITE") eingerichtet und vorgesehen. Das Elektronikmodul weist dabei eine wiederaufladbare Batterie, einen (insbesondere rein, d. h. keine elektrischen Funktionen übernehmenden) mechanischen Halter, in dem die wiederaufladbare Batterie im bestimmungsgemäßen Montagezustand des Elektronikmoduls aufgenommen ist, und einen Schaltungsträger (insbesondere eine Leiterplatte, vorzugsweise eine gedruckte Leiterplatte (auch: "PCB")) auf. Vorzugweise weist das Elektronikmodul ein auf dem Schaltungsträger angeordnetes Mikrophon auf. Außerdem weist das Elektronikmodul einen auf dem Schaltungsträger angeordneten Chipsatz auf. Der Schaltungsträger ist dabei bandartig ausgebildet und im bestimmungsgemäßen Montagezustand abschnittsweise und gebogen um den mechanischen Halter herum gelegt.

Der mechanische Halter wird im Folgenden optional auch als "Frame" oder "Elektronikrahmen" bezeichnet, da dieser wie vorstehend beschrieben zur Halterung zumindest eines Teils der elektrischen und elektronischen Komponenten des Hörinstruments, jedenfalls des Elektronikmoduls dient.

Unter "Chipsatz" wird hier und im Folgenden insbesondere eine Verschaltung mehrerer elektronischer Bauelemente, vorzugsweise inklusive integrierter Schaltkreise, bspw. in Form von Mikroprozessoren und/oder ASICs, verstanden. Insbesondere bildet hier der Chipsatz zumindest einen Audioprozessor (auch: "Signalprozessor") und/oder eine Energiemanagementelektronik. Der Audioprozessor ist vorzugsweise dazu eingerichtet Audiosignale, bspw. mittels des Mikrophons auf Basis empfangenen Luftschalls erzeugte Signale, nutzerspezifisch zu verarbeiten, im Fall eines Hörhilfegeräts insbesondere frequenzabhängig zu filtern und/oder zu verstärken.

Dadurch, dass die PCB gebogen um den Halter und die darin gehaltene Batterie herumgelegt ist, wird vorteilhafterweise eine kompakte Bauweise ermöglicht, insbesondere auch deshalb, da Batterien - auch wiederaufladbare - häufig kleinere Abmessungen aufweisen als für den Einsatz in Hörinstrumenten bestückte PCBs. Somit kann die PCB zumindest grob an die Kontur der Batterie angeglichen werden, was wiederum eine bessere Raumausnutzung ermöglicht.

Die Energiemanagementelektronik ist vorzugsweise dazu eingerichtet, während eines Ladevorgangs der wiederaufladbaren Batterie Ladeenergie zuzuführen, und während eines bestimmungsgemäßen Betriebs des ITE von der wiederaufladbaren Batterie zumindest dem Audioprozessor Betriebsenergie zuzuführen. Vorzugsweise umfasst die Energiemanagementelektronik dazu wenigstens einen Chip in Form eines sogenannten Power Management Integrated Circuit ("PMIC").

Der mechanische Halter ist klammerartig ausgebildet. Im bestimmungsgemäßen Montagezustand umgreift der Halter die wiederaufladbare Batterie teilweise umfangsseitig und wird dabei mittels der PCB in Schließrichtung gehalten, insbesondere gegen ein Aufbiegen gehindert. Vorzugsweise ist der Halter dabei derart belastet, dass eine Klemmkraft auf die Batterie ausgeübt oder erhöht wird. Somit wird die Batterie vorteilhafterweise kraftschlüssig gehalten, was eine Handhabung des Elektronikmoduls während der Montage des ITE vereinfacht. Zweckmäßigerweise ist die PCB außerdem so angeordnet, dass die wiederaufladbare Batterie zumindest teilweise zwischen dem Audioprozessor und der Energiemanagementelektronik angeordnet ist. Anders ausgedrückt, ist die PCB derart gebogen und umgreift die Batterie derart, dass letztere auf einer Art Sehne (im Sinn von Kreisbogensehne, auch wenn die PCB nicht kreisbogenartig gebogen ist, zwischen Audioprozessor und Energiemanagementelektronik angeordnet ist. Dadurch kann die Batterie eine elektromagnetische Schildwirkung entfalten, so dass die elektromagnetische Verträglichkeit des Audioprozessors verbessert wird.

In einer zweckmäßigen Ausführung ist der mechanische Halter im Wesentlichen ringförmig mit einer Ringöffnung, insbesondere also etwa C-förmig, ausgebildet und weist auf einer Außenseite eine von der Ringöffnung weg weisende Einhakstruktur auf. Die PCB weist eine zu der Einhakstruktur korrespondierende Hakenstruktur auf, mittels derer die PCB in die Hakenstruktur eingehakt ist. Beispielsweise ist die Einhakstruktur des Halters in Form einer hakenartigen Hinterschneidung in der Außenfläche des Halters ausgebildet. Eine Verhakung ermöglicht bei der Montage eine vergleichsweise einfache Handhabung, da üblicherweise die einander korrespondierenden Strukturen nur ineinander geschoben werden brauchen.

In einer zweckmäßigen Weiterbildung ist die PCB über die Ringöffnung des (mechanischen) Halters verlaufend angeordnet (erstreckt sich also über die Ringöffnung hinweg). Außerdem ist die PCB auf der der Einhakstruktur gegenüberliegenden Seite der Ringöffnung an dem mechanischen Halter fixiert. Vorzugsweise ist die PCB an dieser Stelle verklebt. Grundsätzlich ist zwar auch hier eine Verhakung möglich. Um aber die vorstehend beschriebene Verspannung einfach ausbilden zu können, ist die Verklebung vorteilhaft, da eine mechanische Verrastung vergleichsweise enge Fertigungstoleranzen zur präzisen Positionierung in Umfangsrichtung erfordert, was wiederum durch eine Verklebung ausgeblichen werden kann.

Zur Bildung der Hakenstruktur der PCB ist vorzugsweise ein Endabschnitt der PCB umgefaltet. Insbesondere weist die PCB einen ersten Endbereich aufweist, in dem auch der vorstehend beschriebene Audioprozessor angeordnet ist, einen in Bandlängsrichtung von dem ersten Endbereich abgegrenzten Mittelbereich und einen zweiten Endbereich, der entgegengesetzt zum ersten Endbereich an den Mittelbereich angrenzt. Der umgefaltete Endabschnitt ist dabei vorzugsweise im ersten Endbereich angeordnet.

Insbesondere ist der Endabschnitt auf einem angrenzenden Teilabschnitt der PCB, insbesondere des ersten Endbereichs, verklebt. Um eine Verhakung mit der Einhakstruktur zu ermöglichen, verbleibt dabei zweckmäßigerweise ein Verhakungsbereich, der insbesondere durch jeweils einen Randstreifen der bandartigen PCB gebildet ist, frei von Klebstoff. In diesem Verhakungsbereich, konkret in diesem Randstreifen, sind zweckmäßigerweise auch keine elektrischen Bauelemente auf die PCB aufgebracht.

Die Einhakstruktur ist entsprechend vorzugsweise durch zwei vom mechanischen Halter abstehende, aber von der Ringöffnung weg weisende, Stege gebildet, unter die die PCB mit ihrem Verhakungsbereich, insbesondere mit dem jeweiligen Randstreifen eingeschoben wird bzw. ist.

Zwischen dem vorstehend genannten Endabschnitt und dem Teilabschnitt (insbesondere des ersten Endbereichs der PCB) liegt wenigstens ein Chip (der vorzugsweise den Audioprozessor oder wenigstens einen Teil dessen bildet) ein. Der Chip gibt dabei mit dessen Bauhöhe einen Mindestabstand zwischen Endabschnitt und Teilabschnitt vor. Vorzugsweise liegen zwei Chips, die gemeinsam den "Kern" des Audioprozessors bilden, zwischen diesen Abschnitten ein. Vorzugsweise ist dabei ein Chip am Endabschnitt und der andere Chip am Teilabschnitt angeordnet, so dass diese im gefalteten Zustand der PCB "Rücken and Rücken" zwischen diesen Abschnitten einliegen. Vorzugsweise geben also beide Chips mit deren Bauhöhe (gegebenenfalls zuzüglich eines Aufschlags für eine Kleberschicht) den Abstand zwischen den beiden Abschnitten vor.

Die Energiemanagementelektronik ist vorzugsweise in dem Mittelbereich der PCB angeordnet. Insbesondere ist in dem Mittelbereich auch das vorstehend genannte Mikrophon angeordnet, vorzugsweise auf einer der wiederaufladbaren Batterie zugewandten Seite der PCB. Dem Mikrophon ist dabei ein Durchbruch ("Schallbohrung") in der PCB zugeordnet, der mit einer Schalleintrittsöffnung des Mikrophons fluchtet. Das Mikrophon ist außerdem zweckmäßigerweise näher zu dem umgefalteten Endabschnitt angeordnet als die Energiemanagementelektronik. Dadurch kann möglichst viel Raum zwischen den Audioprozessor und die Energiemanagementelektronik gebracht werden, so dass im gebogenen Zustand die Batterie möglichst einfach und mit einem möglichst großen Abschnitt zwischen der Energiemanagementelektronik und dem Audioprozessor angeordnet werden kann.

In einer weiteren zweckmäßigen Ausführung ragt von dem Endabschnitt oder dem Teilabschnitt (des ersten Endabschnitts) wenigstens ein Kontaktstreifen der PCB mit Kontaktierungsstellen (insbesondere Lötpads) für wenigstens ein weiteres elektronisches Bauelement über eine Falzkante (d. h. die Kante, um die der Endabschnitt umgefaltet ist) zwischen Endabschnitt und Hauptabschnitt hinaus. Dieser (oder der jeweilige) Kontaktstreifen ist insbesondere durch einen Längsschlitz gebildet, der den Kontaktstreifen von dem Endabschnitt oder dem Teilabschnitt in Längsrichtung trennt und mit dem Teilabschnitt bzw. dem Endabschnitt endseitig (im Bereich der Falzkante) in Verbindung belässt, so dass beim Umfalten des Endabschnitts dieser Kontaktstreifen "aufgerichtet" wird - konkret nicht mit umgefaltet - und über die Falzkante in Verlängerung zum Teilabschnitt bzw. zum Endabschnitt hinaussteht.

Als elektronisches Bauelement, das im bestimmungsgemäßen Endmontagezustand des ITE an dem Kontaktabschnitt elektrisch angeschlossen ist, kommt ein Receiver (Lautsprecher) und/oder eine "MI-Antenne", konkret eine Induktionsspule, die zur kabellosen, magnet-induktiven Signalübertragung eingerichtet ist, zum Einsatz.

In einer weiteren zweckmäßigen Ausführung weist der mechanische Halter, insbesondere in Endbereichen (oder: Randbereichen) beidseitig der Ringöffnung, seitlich vorstehende erste und zweite Positionierungshilfen auf. Unter "seitlich vorstehend" wird dabei insbesondere verstanden, dass diese Positionierungshilfen in Richtung einer Ringachse vorstehen. Diese Positionierungshilfen stehen dabei in einem bestimmungsgemäßen Montagezustand des ITE mit korrespondierenden ersten und zweiten Positionierungshilfen eines Gehäuseelements des Hörinstruments zur gegenseitigen Positionierung in Eingriff.

Insbesondere sind die ersten und zweiten Positionierungshilfen des mechanischen Halters als Pins ausgebildet. Die korrespondierenden Positionierungshilfen des Gehäuseelements sind vorzugsweise als Aussparungen, optional Bohrungen, insbesondere aber als Nuten oder klammerartige Ausnehmungen gebildet, in die die Pins jeweils quer zur Pinachse eingeschoben werden können.

In einer weiteren zweckmäßigen Ausführung weist der mechanische Halter ein Verbolzungsauge (d. h. eine Bohrung) auf, das zur Aufnahme eines Sicherungsstifts zur Verbindung des mechanischen Halters zumindest mit dem Gehäuseelement dient. Die ersten und zweiten Positionierungshilfen sind dabei vorzugsweise dazu eingerichtet, das Verbolzungsauge in einem Zwischenmontageschritt deckungsgleich mit einer korrespondierenden Bohrung im Gehäuseelement des Hörinstruments zu halten. Hierzu sind die korrespondierenden Positionierungshilfen im Gehäuseelement vorzugsweise derart ausgebildet, dass der mechanische Halter in zwei zueinander in einem Winkel (größer Null und kleiner 180 Grad) angestellte Raumrichtungen gehalten wird. Dadurch kann effektiv unterbunden werden, dass sich das am Gehäuseelement befestigte Elektronikmodul, insbesondere zumindest der mechanische Halter verschieben lässt, zumindest abgesehen von einem Spiel innerhalb und aufgrund üblicher Toleranzen.

In einer bevorzugten Ausführung weist das Elektronikmodul eine Ladekontaktanordnung zum Aufladen der wiederaufladbaren Batterie auf. Diese Ladekontaktanordnung ist dabei auf einer von der wiederaufladbaren Batterie abgewandten Seite an der PCB angeordnet. Vorzugsweise umfasst die Ladekontaktanordnung zwei unterschiedlichem elektrischen Potential zugeordnete Ladekontakte.

Die Ladekontaktanordnung ist vorzugsweise in dem zweiten Endbereich der PCB angeordnet und damit am dem umgefalteten Endabschnitt gegenüberliegenden Ende der PCB. Dadurch wird ein auch hinsichtlich der vorstehend genannten EMV-Aspekte vorteilhafter Energie-, insbesondere Stromfluss ermöglicht. Denn während eines Ladevorgangs fließt Strom zweckmäßigerweise zunächst von der Ladekontaktanordnung zu der im benachbarten Mittelbereich (und insbesondere auch benachbart zur Ladekontaktanordnung) angeordneten Energiemanagementelektronik, die den (Lade-) Strom gegebenenfalls wandelt (transformiert) und der Batterie zuführt. Im bestimmungsgemäßen Betrieb des ITE fließt dagegen Betriebsenergie (also insbesondere Strom) von der Batterie über die Energiemanagementelektronik zum vorzugsweise benachbart angeordneten Mikrophon sowie weiter zum ersten Endbereich, konkret zum dort angeordneten Signalprozessor.

Das erfindungsgemäße Hörinstrumente-Grundmodul (kurz: Grundmodul) ist zum Einsatz mit dem vorstehend genannten ITE eingerichtet und vorgesehen. Das Grundmodul weist das vorstehend beschriebene Elektronikmodul sowie das vorstehend angesprochene Gehäuseelement des ITE auf. Das Gehäuseelement weist dabei wenigstens eine Mikrophonöffnung auf. Außerdem ist das Gehäuseelement derart an dem Elektronikmodul befestigt, dass das Mikrophon des Elektronikmoduls durch die Mikrophonöffnung hindurch im bestimmungsgemäßen Endfertigungszustand des ITE mit der Umgebung in fluidischer Verbindung steht. Insbesondere fluchtet also die Mikrophonöffnung mit dem entsprechenden, dem Mikrophon zugeordneten Durchbruch in der PCB sowie der Schalleintrittsöffnung des Mikrophons.

Bevorzugt weist das Elektronikmodul eine Ringdichtung auf, welche die Mikrophonöffnung umlaufend der PCB und dem Gehäuseelement zwischengeordnet ist. Das Elektronikmodul ist dabei zweckmäßigerweise mittels der jeweiligen ersten und zweiten Positionierungshilfen (des mechanischen Halters sowie des Gehäuseelements) unter Belastung der Ringdichtung gegen das Gehäuseelement verspannt. Dadurch wird vorteilhafterweise der Dichtungsdruck zwischen Gehäuseelement und Elektronikmodul aufgebracht.

In einer bevorzugten Ausführung ist das Gehäuseelement im Wesentlichen L-förmig mit einem langen Schenkel und einem dazu in einem etwa rechten Winkel (d. h. vorzugsweise zwischen 75 und 110 Grad) angestellten kurzen Schenkel ausgebildet. Die Mikrophonöffnung ist dabei im langen Schenkel, vorzugsweise in einem Freiendbereich des langen Schenkels, angeordnet. Der lange Schenkel bildet im bestimmungsgemäßen Endmontagezustand des ITE einen zum offenen Ende des Gehörgangs weisenden Gehäuseabschluss, klassischerweise auch als "faceplate" bezeichnet. In dem kurzen Schenkel ist eine Ladeöffnung angeordnet, durch die hindurch die Ladekontaktanordnung zugänglich ist. Der kurze Schenkel ist im bestimmungsgemäßen Tragezustand des ITE vorzugsweise etwa parallel zur Gehörgangwand angeordnet und somit von der Ohrmuschel aus nicht sichtbar. Zweckmäßigerweise ist um die Ladeöffnung umlaufend eine (weitere) Ringdichtung dem Gehäuseelement und der PCB zwischengelagert, damit ein Eindringen von Verunreinigungen zwischen das Gehäuseelement und die PCB verhindert wird.

Vorzugsweise ist das Grundmodul, zumindest das Gehäuseelement, hinsichtlich der geometrischen Außenstrukturen, d. h. der Strukturen, die von einer Außenseite im bestimmungsgemäßen Endmontagezustand sichtbar sind sowie die zur mechanischen Verbindung mit weiteren Bauelementen des ITE dienen, symmetrisch aufgebaut. Dadurch kann das Grundmodul gleichermaßen für "linke" und "rechte" (also zum Tragen im linken bzw. rechten Ohr vorgesehene) ITEs eingesetzt werden, so dass die Anzahl von Gleichteilen bei der Fertigung vorteilhafterweise erhöht werden kann.

Das erfindungsgemäße ITE weist das vorstehend beschriebene Grundmodul auf. Des Weiteren weist das ITE ein Hauptgehäuse auf, das eine im bestimmungsgemäßen Tragezustand dem Trommelfell abgewandte Gehäuseöffnung aufweist. Das Grundmodul ist in das Hauptgehäuse eingesetzt und verschließt mit dem Gehäuseelement diese Gehäuseöffnung. Vorzugsweise weist das Hauptgehäuse eine Befestigungsbohrung auf, durch die hindurch ein Sicherungsstift (insbesondere der vorstehend genannte Sicherungsstift) derart verläuft, dass dieser die Bohrung des Gehäuseelements und das Verbolzungsauge des mechanischen Halters ebenfalls durchläuft, wodurch drei Bauelemente durch ein gemeinsames Verbindungselement aneinander gesichert sind.

Die vorstehend beschriebenen ersten und zweiten Positionierungshilfen des mechanischen Halters sowie des Gehäuseelements dienen mithin vorteilhafterweise zur mechanischen Ausrichtung und Fixierung des Elektronikmoduls mit dem Gehäuseelement zu einer Montagezwischenbaugruppe.

Vorzugsweise weist das ITE auch den vorstehend genannten Receiver und/oder die MI-Antenne auf, die vorzugsweise eine gemeinsame, integrierte Baugruppe bilden, und die in dem Hauptgehäuse angeordnet sowie mit dem korrespondierenden Kontaktstreifen bzw. den darauf angeordneten Lötpads kontaktiert sind.

Das Grundmodul sowie auch das ITE weisen mithin die sich aus der Beschreibung des Elektronikmoduls ergebenden Merkmale sowie daraus hervorgehenden Vorteile gleichermaßen auf.

Ein ebenfalls eine eigenständige Erfindung bildendes Montageverfahren für das Elektronikmodul, weiterführend für das Grundmodul sowie das ITE, umfasst mithin die Schritte (folgende Beschreibung basierend auf den vorstehend beschriebenen Bauelementen):
- Bereitstellen des mechanischen Halters,
- Bereitstellen der wiederaufladbaren Batterie,
- Bereitstellen der PCB
- Bereitstellen des Chipsatzes sowie dessen Anordnung auf der PCB,
- Einlegen der Batterie in den mechanischen Halter, und
- Herumlegen und Befestigen der PCB um den bzw. an dem mechanischen Halter;
außerdem (zur Ausbildung des Grundmoduls) insbesondere:
- Bereitstellen des Gehäuseelements und
- Verbinden des Elektronikmoduls, vorzugsweise unter Ineingriffbringen der jeweiligen ersten und zweiten Positionierungshilfen mit dem Gehäuseelement;
sowie (zur Ausbildung des ITE):
- Bereitstellen des (vorzugsweise seitenabhängigen, also des linken oder rechten) Hauptgehäuses,
- Einlegen des Grundmoduls in das Hauptgehäuse, und
- Fixieren das Grundmoduls in dem Hauptgehäuse.

Die Konjunktion "und/oder" ist hier und im Folgenden insbesondere derart zu verstehen, dass die mittels dieser Konjunktion verknüpften Merkmale sowohl gemeinsam als auch als Alternativen zueinander ausgebildet sein können.

Nachfolgend wird ein Ausführungsbeispiel der Erfindung anhand einer Zeichnung näher erläutert. Darin zeigen:
- Fig. 1: in einer Perspektivansicht schematisch ein in dem Gehörgang zu tragendes Hörinstrument,
- Fig. 2: in einer Explosionsansicht schematisch das Hörinstrument,
- Fig. 3: in einer Perspektivansicht schematisch eine Batteriezelle des Hörinstruments und einen mechanischen Halter für diese,
- Fig. 4-7: jeweils in unterschiedlichen Ansichten schematisch einen Schaltungsträger des Hörinstruments in teilweise unterschiedlichen Montagezuständen,
- Fig. 8: in einer Seitenansicht schematisch ein durch die Batteriezelle, den Halter und den Schaltungsträger gebildetes Elektronikmodul des Hörinstruments,
- Fig. 9: in Ansicht gemäß Fig. 8 schematisch ein durch das Elektronikmodul und ein Gehäuseelement gebildetes Grundmodul des Hörinstruments,
- Fig. 10: in einer Draufsicht auf eine Oberseits schematisch das Grundmodul,
- Fig. 11: in Ansicht gemäß Fig. 8 schematisch das Grundmodul sowie ein Hauptgehäuse des Hörinstruments in einem Zwischenfertigungszustand,
- Fig. 12: in einer weiteren Perspektivansicht schematisch das Hörinstrument.

Einander entsprechende Teile sind in allen Figuren stets mit gleichen Bezugszeichen versehen.

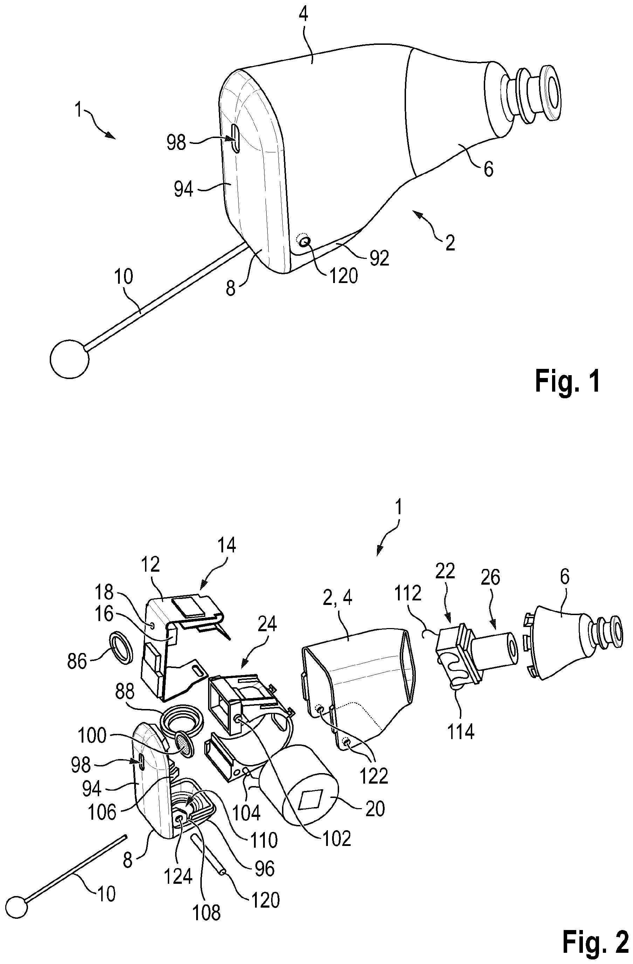

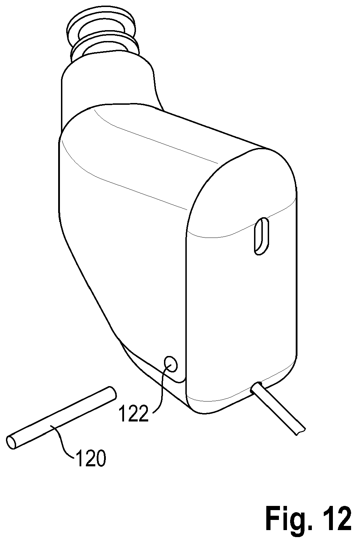

In Fig. 1 ist schematisch ein Hörinstrument dargestellt, das zum Tragen im Gehörgang eingerichtet und vorgesehen ist und deshalb im Folgenden als ITE 1 (für "in the ear") bezeichnet wird. Das ITE 1 weist ein Außengehäuse 2 auf, das im vorliegenden Ausführungsbeispiel durch mehrere Gehäuseelemente gebildet ist. Ein Gehäuseelement bildet ein Hauptgehäuse 4 (auch als Gehäusemittelteil bezeichnet), ein weiteres Gehäuseelement bildet eine im bestimmungsgemäßen Tragezustand dem Trommelfell zugewandte Gehäusespitze 6 und ein drittes Gehäuseelement bildet einen Gehäusedeckel 8, der im bestimmungsgemäßen Tragezustand dem außenseitigen Ende des Gehörgangs zugewandt oder an diesem angeordnet ist. Ein Cerumenschutz sowie ein Ohrstück (auch als "dome" bezeichnet) sind in Fig. 1 bis 12 nicht näher dargestellt. Außerdem weist das ITE 1 einen am Gehäusedeckel 8 befestigten Ausziehfaden 10 auf.

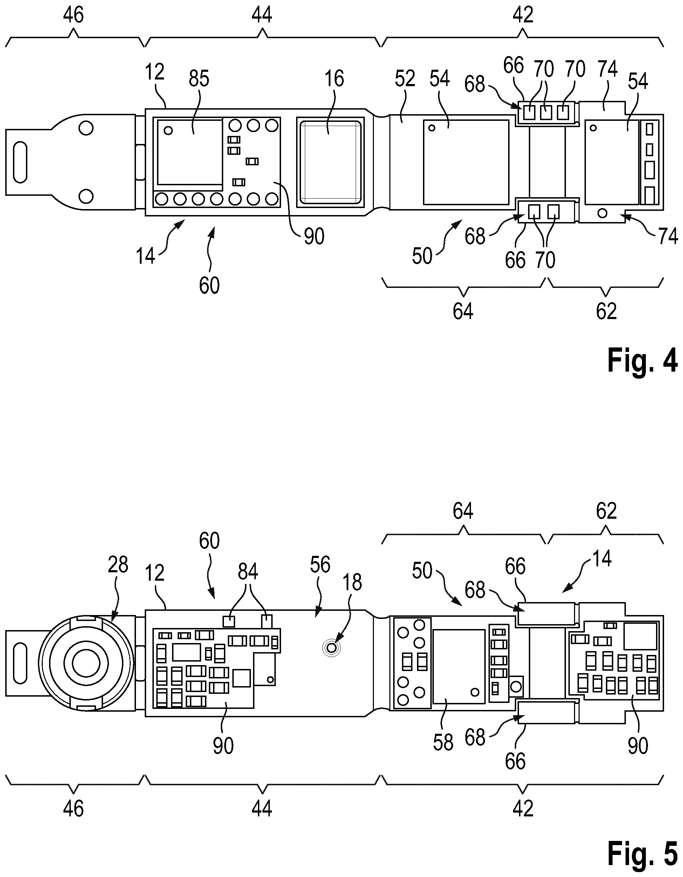

In Fig. 2 sind schematisch weitere Komponenten des ITE 1 dargestellt. Das ITE 1 weist dabei einen Schaltungsträger (kurz als "PCB 12" bezeichnet) auf, auf dem elektronische Bauelemente in Form eines - mehrere integrierte Schaltkreise und Elektronikkomponenten umfassenden - Chipsatzes 14 angeordnet sind (s. Fig. 4, 5). Des Weiteren ist auf der PCB 12 ein Mikrophon 16 angeordnet, das dabei mit einer nicht dargestellten Schalleintrittsöffnung deckungsgleich zu einer Schallbohrung 18 in der PCB 12 angeordnet ist. Außerdem weist das ITE 1 eine wiederaufladbare Batterie 20 auf, sowie einen Lautsprecher 22. Der Batterie 20 ist ein mechanischer Halter (kurz: "Frame 24") zugeordnet, in dem die Batterie 20 in nachfolgend näher erläuterter Weise aufgenommen ist. Außerdem weist das ITE 1 auch eine MI-Antenne 26 auf, die für eine magnetinduktive Kommunikation zwischen zwei ITE 1 im Rahmen eines binauralen Hörsystems eingerichtet ist. Diese MI-Antenne 26 ist auf einem Lautsprecher-Ausgangskanal ("spout", nicht dargestellt) angeordnet. Zum Laden der wiederaufladbaren Batterie 20 weist das ITE 1 auch eine Ladekontaktanordnung 28 auf (s. Fig. 5). Die Anordnung dieser Komponenten sowie weitere Komponenten wird im Folgenden näher beschrieben.

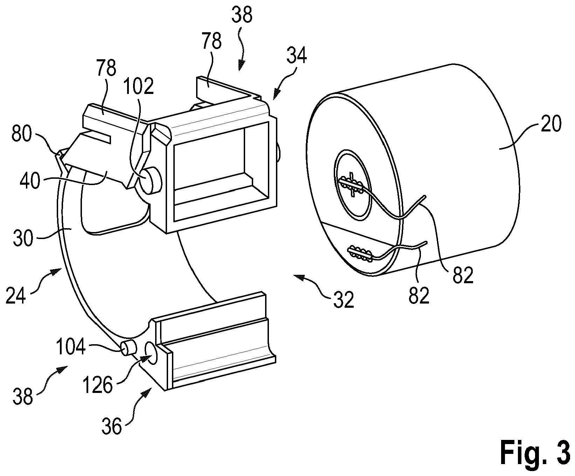

In Fig. 3 ist der Frame 24 näher dargestellt. Der Frame 24 ist dabei grob C-förmig ausgebildet, d. h. weist einen etwa einen Dreiviertelkreis beschreibenden Ringkörper 30 auf, der durch eine Ringöffnung 32 unterbrochen ist. An den über die Ringöffnung 32 gegenüberliegenden oberen und unteren Enden 34 und 36 des Ringkörpers 30 sind nachfolgend näher beschriebene Befestigungsstrukturen 38 ausgebildet. Der Ringkörper 32 ist derart bemessen, dass die Batterie 20 axial in den Ringkörper 32 - vorzugsweise unter geringförmiger Klemmung - eingesetzt werden kann. Der Frame 24 bildet mithin eine Klammer für die Batterie 20. Zur axialen Sicherung der Batterie 20 in Einschieberichtung, d. h. als axialen Anschlag, weisen die Befestigungsstrukturen 38 des oberen Endes 38 eine radial nach innen vorstehende Schulter 40 auf, an der die Batterie 20 bei der Montage im Frame 24 anliegt. Die Batterie 20 ist vergleichbar zu einer Knopfzelle kreiszylindrisch ausgebildet.

Die PCB 12 ist in Fig. 4 und 5 in einem Zwischenfertigungsschritt dargestellt. Die PCB 12 ist grob bandförmig, d. h. vergleichsweise lang und schmal, ausgebildet. Die PCB 12 ist dabei in einen ersten Endbereich 42, einen an diesen anschließenden Mittelbereich 44 und einen zweiten, an den Mittelbereich 44 auf der dem ersten Endbereich 42 gegenüberliegenden Seite anschließenden Endbereich 46 unterteilt. Der Chipsatz 14 ist dabei ebenfalls unterteilt. In dem ersten Endbereich 42 ist ein Teil des Chipsatzes 14 angeordnet, der einen Audioprozessor 50 bildet. Dazu sind hier auf einer späteren "Innenseite" 52 zwei Chips 54 angeordnet und auf einer späteren "Außenseite" 56 ein Speicherchip 58. In dem Mittelbereich 44 bildet der Chipsatz 14 eine Energiemanagementelektronik 60 aus. Dieser und dem Audioprozessor 50 ist das Mikrophon 16 auf den Innenseite 52 zwischengelagert. Im zweiten Endbereich 46 ist außenseitig die Ladekontaktanordnung 28 angeordnet.

Der erste Endbereich 42 ist nochmals unterteilt in einen Endabschnitt 62 und einen dem Mittelbereich 44 zugewandten Teilabschnitt 64. Randseitig zu dem Teilabschnitt 64 sind zwei Kontaktstreifen 66 mittels eines L-förmigen Schlitzes 68 aus der PCB 12 herausgearbeitet. Jeder dieser Kontaktstreifen 66 trägt mehrere Lötpads 70.

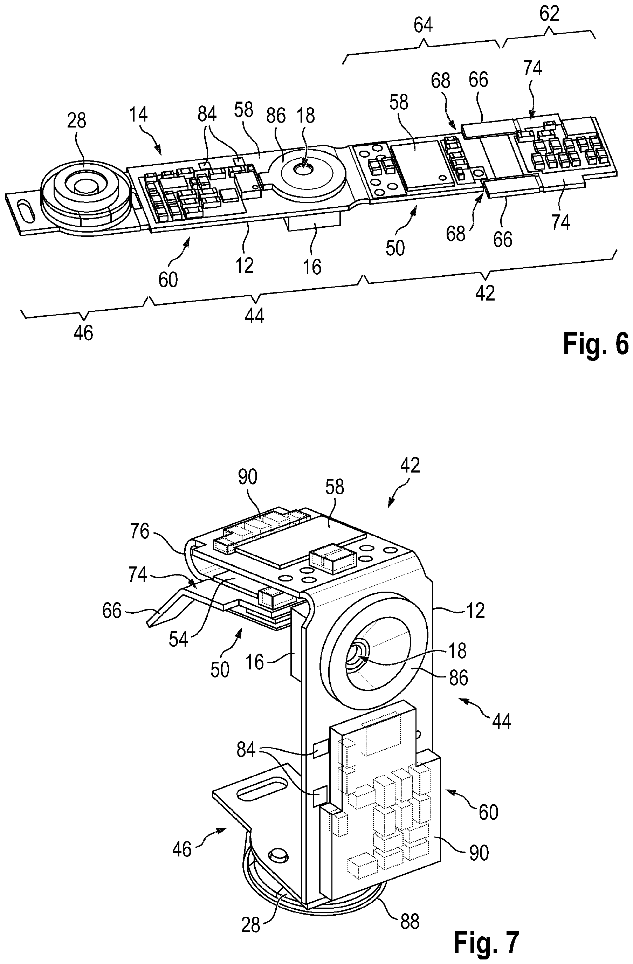

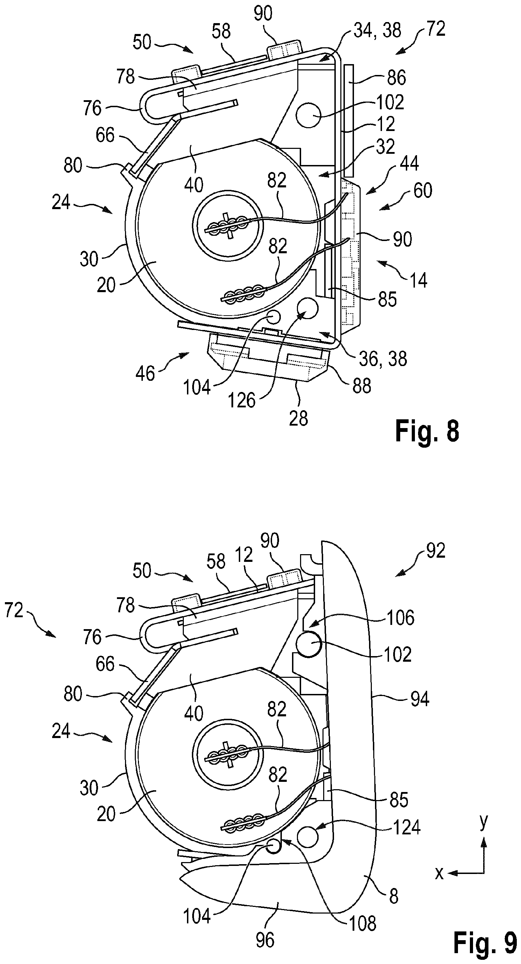

Anhand von Fig. 7 und 8 ist schematisch dargestellt, wie aus dem Frame 24, der Batterie 20 und der PCB 12 ein Elektronikmodul 72 gebildet wird. Dazu wird der Endabschnitt 62 der PCB 12 zur Innenseite 52 hin umgefaltet, so dass die beiden Chips 54 mit ihren Rückseiten aneinander anliegen. Im Bereich der Chips 54 werden der Endabschnitt 62 und der Teilabschnitt 64 miteinander verklebt, und zwar derart, dass randseitig ein Verhakungsbereich (oder Randstreifen 74) ohne Klebstoff verbleibt. Durch das Umfalten des Endabschnitts 62 wird eine hakenartige Struktur gebildet. Die Kontaktstreifen 66 stehen dabei über eine zwischen dem Endabschnitt 62 und dem Teilabschnitt 64 verlaufende Falzkante 76 über. Außerdem wird die PCB 12 an jedem Übergang vom Mittelbereich 44 auf den jeweilige Endbereich 42 bzw. 46 zu einer etwa C-artigen Form geknickt (gefaltet).

Die Batterie 20 wird in den Frame 24 eingesetzt. Der Frame 24 weist am oberen Ende 34 als Teil der Befestigungsstrukturen 38 eine Einhakstruktur in Form von zwei Rahmenstegen 78 auf, die von der Ringöffnung 32 weg gerichtet sind und somit eine Hinterschneidung bilden. In diese Hinterschneidung, konkret den Spalt zwischen dem jeweiligen Rahmensteg 78 (und dem Ringkörper 30) wird die PCB 12 mit dem jeweiligen Randstreifen 74 eingeschoben (eingehalt) und somit in Tangentialrichtung in Richtung auf die Ringöffnung 32 gesichert.

Die Kontaktstreifen 66 werden in Richtung auf die Batterie 20 gebogen und unter einer jeweils zugeordneten Haltenase 80 der Befestigungsstrukturen 38 des oberen Endes 34 des Ringkörpers 30 eingehakt und somit gesichert.

Der Mittelbereich 44 der PCB 12 wird über die Ringöffnung 32 und der zweite Endbereich 46 über das untere Ende 36 des Frames 24 gelegt. Außerdem wird der zweite Endbereich 46 mit dem unteren Ende 36 verklebt und ist somit an dem Frame 24 fixiert. Durch dieses Herumbiegen und Herumlegen der PCB 12 um den Frame 24 wird letzterer in "Schließrichtung" belastet, d. h. eine Klemmwirkung auf die Batterie 20 aufgebracht oder die gegebenenfalls bereits vorhandene Klemmwirkung erhöht. Zumindest ist der Frame 24 gegen ein Aufbiegen gesichert, so dass die Batterie 20 nicht unbeabsichtigt herausfallen kann.

Anschließend werden Kontaktleitungen 82 der Batterie 20 mit korrespondierenden Kontaktanschlüssen (Lötpads 84) der PCB 12, die der Energieverteilungselektronik 60 zugeordnet sind, verbunden, konkret verlötet.

Wie aus Fig. 8 ersichtlich ist, ist die Batterie 20 zumindest teilweise auf einer gedachten, direkten Verbindungslinie zwischen der Energiemanagementelektronik 60 und dem Audioprozessor 50 angeordnet. Zumindest ist die Batterie 20 zwischen einem Chip 85 (insbesondere ein PMIC) der Energiemanagementelektronik 60 und dem Audioprozessor 50, konkret dessen Chips 54, angeordnet. Dadurch kann die Batterie 20 vorteilhafterweise als Schirmung zwischen diesen Chips 54 bzw. 85 dienen, so dass eine elektromagnetische Störung des Audioprozessors 50 vermieden oder verringert wird.

Auf der PCB 12 sind des Weiteren im Bereich um die Schallbohrung 18 eine Ringdichtung ("Mikrophondichtung 86") und um die Ladekontaktanordnung 28 eine weitere Ringdichtung ("Dichtungsring 88") angeordnet, insbesondere auf die PCB 12 geklebt. Wie aus Fig. 4, 5 und 7 hervorgeht, sind die elektronischen Bauelemente der PCB 12 außerdem mit einem Gießharz 90 überzogen (durchsichtig dargestellt).

Gemeinsam mit dem Gehäusedeckel 8 und dem Elektronikmodul 72 wird ein Grundmodul 92 für das ITE 1 gebildet. Der Gehäusedeckel 8 ist L-förmig mit einem langen Schenkel 94 und einem kurzen Schenkel 96, der etwa 85 Grad zu dem langen Schenkel 94 angestellt ist, ausgebildet. In dem langen Schenkel 94 ist korrespondierend zu der Schallbohrung 18 und der Mikrophondichtung 86 eine Mikrophonöffnung 98 angeordnet, um das Mikrophon 16 fluidisch mit der Umgebung zu verbinden. Innenseitig ist vor der Mikrophonöffnung 98 ein Schutzgitter 100, konkret ein Monofil-Gitter, angeordnet (s. Fig. 1). Des Weiteren wird der Ausziehfaden 10 in den Gehäusedeckel 8 eingeklebt.

Zur Verbindung des Elektronikmoduls 72 mit dem Gehäusedeckel 8 sind am Frame 24 und am Gehäusedeckel 8 jeweils erste und zweite Positionierungshilfen ausgebildet. Die ersten und zweiten Positionierhilfen des Frames 24 sind dabei Teil der Befestigungsstrukturen 38 und als ein Rastpin 102 (erste Positionierungshilfe) und als ein Positionierpin 104 (zweite Positionierungshilfe) ausgebildet. Als erste Positionierungshilfe ist am langen Schenkel 94 eine etwa C-förmige Klammer 106 ausgebildet. Am kurzen Schenkel 96 des Gehäusedeckels 8 ist als zweite Positionierungshilfe eine U-förmige Nut 108 ausgebildet. Bei der Montage wird das Elektronikmodul 72 zunächst mit dem Positionierpin 104 in die Nut 108 eingesetzt, die eine Verschiebung des Elektronikmoduls 72 in einer x-Richtung verhindert, und anschließend mit dem Rastpin 102 in die Klammer 106 eingeclipst (verrastet). Letzteres verhindert eine Verschiebung in y-Richtung. Die Verclipsung (Verrastung) erfolgt dabei unter Kompression sowohl der Mikrophondichtung 86 also auch des Dichtungsrings 88 zwischen PCB 12 und Gehäusedeckel 8. Der Dichtungsring 88 umrandet dabei eine Ladeöffnung 110 im kurzen Schenkel 96 des Gehäusedeckels 8 (s. Fig. 1), so dass die Ladekontaktanordnung 28 von außen zugänglich ist.

Das Grundmodul 92 stellt dabei ein in sich stabiles Zwischenfertigungsmodul dar. Dieses wird anschließend mit den restlichen Komponenten des ITE 1 verbunden.

Dazu wird zunächst der Lautsprecher 22 (mit der daran angeordneten MI-Antenne 26) in die Gehäusespitze 6 eingesetzt, konkret dichtend um eine Schallaustrittsöffnung der Gehäusespitze 6 verklebt. Anschließend wird die Gehäusespitze 6 in das Hauptgehäuse 4 eingeclipst.

Zweipolige Kontaktleitungen 112 der MI-Antenne 26 und dreipolige Kontaktleitungen 114 des Lautsprechers 22 werden mit den auf den Kontaktstreifen 66 angeordneten Lötpads 70 kontaktiert, konkret verlötet (nicht näher dargestellt).

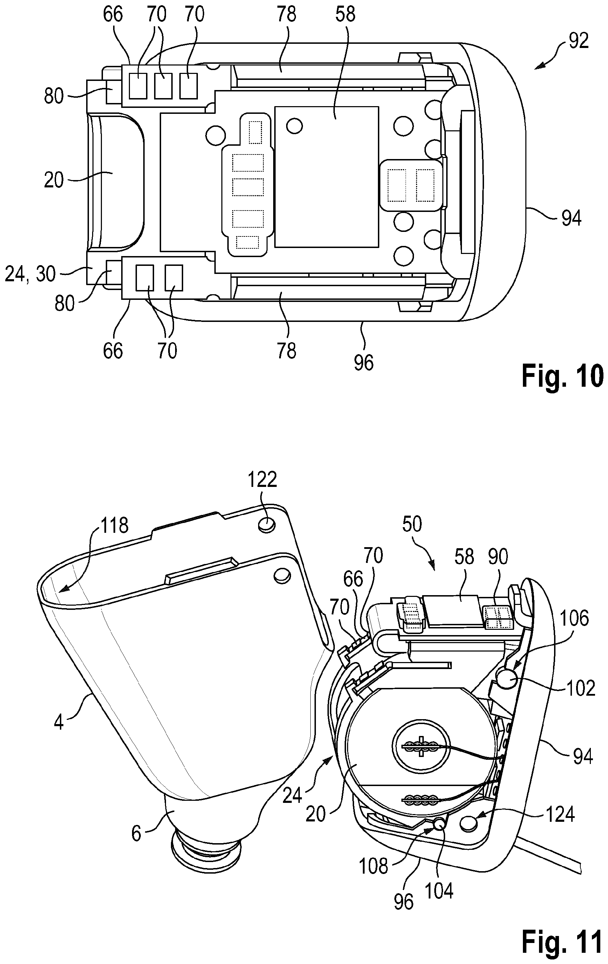

Anschließend wird das Grundmodul 12 mit einem am Gehäusedeckel 8, konkret am freien Ende des langen Schenkels 94, ausgebildeten Haken 116 in eine korrespondierende Nut 118 im Hauptgehäuse 4 eingeschoben und dann mit dem kurzen Schenkel 96 voran in das Hauptgehäuse 4 eingeschwenkt (vgl. Fig. 11). Anschließend wird ein Sicherungsstift 120 durch eine Befestigungsbohrung 122 im Hauptgehäuse 4 gesteckt. Der Sicherungsstift 120 verläuft dabei durch eine korrespondierende Bohrung 124 des Gehäusedeckels 8 und durch ein Verbolzungsauge 126 des Frames 24 (das wiederum Teil der Befestigungsstrukturen 38 ist), wodurch der Frame 24, der Gehäusedeckel 8 und das Hauptgehäuse 4 durch nur ein gemeinsames Verbindungselement aneinander gesichert sind.

Das vorstehend beschriebene Zusammenwirken der ersten und zweiten Positionierungshilfen des Frames 24 und des Gehäusedeckels 8 hält diese beiden Teile nicht nur zusammen, sondern positioniert auch Verbolzungsauge 126 und Bohrung 124 fluchtend zueinander. Dadurch wird die Montage des Sicherungsstifts 120 vereinfacht.

Die Positionierung der Ladekontaktanordnung 28 im zweiten Endbereich 46, der Energiemanagementelektronik 60 im Mittelbereich 44 und des Audioprozessors 50 im ersten Endbereich 42 hat - neben der vorstehend beschriebenen Nutzung der Batterie 20 als Schirmung im bestimmungsgemäßen Montagezustand - auch den Vorteil, dass ein Energiefluss zweckmäßig ausgelegt ist. Während des Ladens wird von der Ladekontaktanordnung 28 auf, im Vergleich zur Länge der PCB 12, kurzem Weg Ladeenergie der Energiemanagementelektronik 60 (die auch die Funktion einer Ladeelektronik übernimmt) und von dieser der Batterie 20 - ebenfalls auf kurzem Weg - zugeführt. Im "Audio-Betrieb" des ITE 1 ist der "Ast" zur Ladekontaktanordnung inaktiv und die Energie wird von der Batterie 20 über die Energiemanagementelektronik 60 als Betriebsenergie dem Mikrophon 16 und dem Audioprozessor 50 sowie mittelbar über diesen dem Lautsprecher 22 zugeführt.

Der Gegenstand der Erfindung ist nicht auf das vorstehend beschriebene Ausführungsbeispiel beschränkt. Vielmehr können weitere Ausführungsformen der Erfindung von dem Fachmann aus der vorstehenden Beschreibung abgeleitet werden.

### Bezugszeichenliste

- 1: ITE
- 2: Außengehäuse
- 4: Hauptgehäuse
- 6: Gehäusespitze
- 8: Gehäusedeckel
- 10: Ausziehfaden
- 12: PCB
- 14: Chipsatz
- 16: Mikrophon
- 18: Schallbohrung
- 20: Batterie
- 22: Lautsprecher
- 24: Frame
- 26: MI-Antenne
- 28: Ladekontaktanordnung
- 30: Ringkörper
- 32: Ringöffnung
- 34: Ende
- 36: Ende
- 38: Befestigungsstruktur
- 40: Schulter
- 42: Endbereich
- 44: Mittelbereich
- 46: Endbereich
- 50: Audioprozessor
- 52: Innenseite
- 54: Chip
- 56: Außenseite
- 58: Speicherchip
- 60: Energiemanagementelektronik
- 62: Endabschnitt
- 64: Teilabschnitt
- 66: Kontaktstreifen
- 68: Schlitz
- 70: Lötpad
- 72: Elektronikmodul
- 74: Randstreifen
- 76: Falzkante
- 78: Rahmensteg
- 80: Haltenase
- 82: Kontaktleitung
- 84: Lötpad
- 86: Mikrophondichtung
- 88: Dichtungsring
- 90: Gießharz
- 92: Grundmodul
- 94: Schenkel
- 96: Schenkel
- 98: Mikrophonöffnung
- 100: Schutzgitter
- 102: Rastpin
- 104: Positionierungspin
- 106: Klammer
- 108: Nut
- 110: Ladeöffnung
- 112: Kontaktleitung
- 114: Kontaktleitung
- 116: Haken
- 118: Nut
- 120: Sicherungsstift
- 122: Befestigungsbohrung
- 124: Bohrung
- 126: Verbolzungsauge

## Patentansprüche

1. Elektronikmodul (72) für ein im Gehörgang zu tragendes Hörinstrument (1), aufweisend
- eine wiederaufladbare Batterie (20),
- einen mechanischen Halter (24), in dem die wiederaufladbare Batterie (20) im bestimmungsgemäßen Montagezustand des Elektronikmoduls (72) aufgenommen ist,
- einen Schaltungsträger (12), und
- einen auf dem Schaltungsträger (12) angeordneten Chipsatz (14), wobei der Schaltungsträger (12) bandartig ausgebildet ist und im bestimmungsgemäßen Montagezustand abschnittsweise und gebogen um den mechanischen Halter (24) herum gelegt ist,
wobei der mechanische Halter (24) klammerartig ausgebildet ist und im bestimmungsgemäßen Montagezustand die wiederaufladbare Batterie (20) teilweise umfangsseitig umgreift, und wobei der mechanische Halter (24) mittels des Schaltungsträgers (12) in Schließrichtung gehalten ist.

2. Elektronikmodul (72) nach Anspruch 1,
wobei der mechanische Halter (24) mittels des Schaltungsträgers (12) in Schließrichtung belastet ist, so dass eine Klemmkraft auf die Batterie (20) ausgeübt oder erhöht wird.

3. Elektronikmodul (72) nach Anspruch 1 oder 2,
wobei der mechanische Halter (24) im Wesentlichen ringförmig mit einer Ringöffnung (32) ausgebildet ist und auf einer Außenseite eine von der Ringöffnung (32) weg weisende Einhakstruktur (78) aufweist, wobei der Schaltungsträger (12) eine korrespondierende Hakenstruktur aufweist, mittels derer der Schaltungsträger (12) in die Einhakstruktur (78) eingehakt ist.

4. Elektronikmodul (72) nach Anspruch 2 und 3,
wobei der Schaltungsträger (12) über die Ringöffnung (32) verlaufend angeordnet und auf der der Einhakstruktur (78) gegenüberliegenden Seite der Ringöffnung (32) an dem mechanischen Halter (24) fixiert, insbesondere verklebt, ist.

5. Elektronikmodul (72) nach Anspruch 3 oder 4,
wobei zur Bildung der Hakenstruktur des Schaltungsträgers (12) ein Endabschnitt (62) umgefaltet ist.

6. Elektronikmodul (72) nach Anspruch 5,
wobei der Endabschnitt (62) auf einem angrenzenden Teilabschnitt (64) des Schaltungsträgers (12) verklebt ist, wobei ein Verhakungsbereich frei von Klebstoff verbleibt.

7. Elektronikmodul (72) nach Anspruch 5 oder 6,
wobei zwischen Endabschnitt (62) und Teilabschnitt (64) wenigstens ein Chip (54) einliegt und mit dessen Bauhöhe einen Mindestabstand zwischen Endabschnitt (62) und Teilabschnitt (64) vorgibt.

8. Elektronikmodul (72) nach einem der Ansprüche 5 bis 7,
wobei von dem Endabschnitt (62) oder dem Teilabschnitt (64) wenigstens ein Kontaktstreifen (66) des Schaltungsträgers (12) mit Kontaktierungsstellen (70) für wenigstens ein weiteres elektronisches Bauelement über eine Falzkante (76) zwischen Endabschnitt (62) und Teilabschnitt (64) hinausragt.

9. Elektronikmodul (72) nach einem der Ansprüche 1 bis 8,
wobei der mechanische Halter (24), insbesondere in Endbereichen beidseitig der Ringöffnung (32), seitlich vorstehende erste und zweite Positionierungshilfen (102, 104) aufweist, die in einem bestimmungsgemäßen Montagezustand des Hörinstruments (1) mit korrespondierenden ersten und zweiten Positionierungshilfen eines Gehäuseelements (8) des Hörinstruments (1) zur gegenseitigen Positionierung in Eingriff stehen.

10. Elektronikmodul (72) nach Anspruch 9,
wobei die ersten und zweiten Positionierungshilfen des mechanischen Halters (24) als Pins (102, 104) ausgebildet sind.

11. Elektronikmodul (72) nach einem der Ansprüche 1 bis 10,
wobei der mechanische Halter (24) ein Verbolzungsauge (126) aufweist, das zur Aufnahme eines Sicherungsstifts (120) zur Verbindung des mechanischen Halters (24) zumindest mit dem Gehäuseelement (8) dient, insbesondere wobei die ersten und zweiten Positionierungshilfen (102, 104) dazu eingerichtet sind, das Verbolzungsauge (0126) in einem Zwischenmontageschritt deckungsgleich mit einer korrespondierenden Bohrung im Gehäuseelement (8) des Hörinstruments (1) zu halten.

12. Elektronikmodul (72) nach einem der Ansprüche 1 bis 11,
aufweisend eine Ladekontaktanordnung (28) zum Aufladen der wiederaufladbaren Batterie (20), wobei die Ladekontaktanordnung (28) auf einer von der wiederaufladbaren Batterie (20) abgewandten Seite an dem Schaltungsträger (12) angeordnet ist.

13. Elektronikmodul (72) nach Anspruch 5 und 12,
wobei die Ladekontaktanordnung (28) in dem Endbereich (46) des Schaltungsträgers (12) angeordnet ist, der dem umgefalteten Endabschnitt (62) gegenüberliegt.

14. Hörinstrumente-Grundmodul (92) für ein im Gehörgang zu tragendes Hörinstrument (1), aufweisend ein Elektronikmodul (72) gemäß einem der Ansprüche 1 bis 11 sowie ein Gehäuseelement (8) des Hörinstruments (1), wobei das Gehäuseelement (8) wenigstens eine Mikrophonöffnung (98) aufweist und derart an dem Elektronikmodul (72) befestigt ist, dass das Mikrophon (16) des Elektronikmoduls (72) durch die Mikrophonöffnung (98) hindurch im bestimmungsgemäßen Endfertigungszustand des Hörinstruments (1) mit der Umgebung in fluidischer Verbindung steht.

15. Hörinstrumente-Grundmodul (92) nach Anspruch 14,
wobei das Elektronikmodul (72) eine Ringdichtung (86) aufweist, die dem Schaltungsträger (12) und dem Gehäuseelement (8) die Mikrophonöffnung (98) umlaufend zwischengeordnet ist, und wobei das Elektronikmodul (72) mittels der ersten und zweiten Positionierungshilfen (102, 104) unter Belastung der Ringdichtung (86) gegen das Gehäuseelement (8) verspannt ist.

16. Hörinstrumente-Grundmodul (92) nach Anspruch 14 oder 15,
wobei das Gehäuseelement (8) im Wesentlichen L-förmig mit einem langen Schenkel (94) und einem dazu in einem etwa rechten Winkel angestellten kurzen Schenkel (96) ausgebildet ist, wobei die Mikrophonöffnung (98) in dem langen Schenkel (94) angeordnet ist und wobei in dem kurzen Schenkel (96) eine Ladeöffnung (110) angeordnet ist, durch die hindurch die Ladekontaktanordnung (28) zugänglich ist, insbesondere wobei um die Ladeöffnung (110) umlaufend eine Ringdichtung (88) dem Gehäuseelement (8) und dem Schaltungsträger (12) zwischengelagert ist.

17. Im Gehörgang zu tragendes Hörinstrument (1) aufweisend ein Hörinstrumente-Grundmodul (92) nach einem der Ansprüche 14 bis 16 und mit einem Hauptgehäuse (4), das eine im bestimmungsgemäßen Tragezustand dem Trommelfell abgewandte Gehäuseöffnung aufweist, wobei das Hörinstrumente-Grundmodul (92) in das Hauptgehäuse (4) eingesetzt ist und mit dem Gehäuseelement (8) die Gehäuseöffnung verschließt, insbesondere wobei das Hauptgehäuse (4) eine Befestigungsbohrung (122) aufweist, durch die hindurch ein Sicherungsstift (120) derart verläuft, dass dieser die Bohrung (124) des Gehäuseelements (8) und das Verbolzungsauge (126) des mechanischen Halters (24) durchläuft.
